# EUROPEAN PATENT SPECIFICATION

(11) **EP 0 643 449 B1**
(45) Date of publication and mention of the grant of the patent: **15.07.1998**
(21) Application number: 94203022.2
(22) Date of filing: 17.04.1989
(51) Int. Cl.: H01R 23/66

(54) **Cable connector for a ribbon cable**
Verbinder für Bandkabel
Connecteur pour câble-ruban

(43) Date of publication of application: 15.03.1995
(62) Divisional of application: 89200986.1
(73) Proprietor: CONNECTOR SYSTEMS TECHNOLOGY N.V., Willemstad, Curaçao (AN); BERG ELECTRONICS MANUFACTURING B.V., 5222 AV s'-Hertogenbosch (NL)
(72) Inventor: Verhoeven, Laurentius Maria, NL-5465 RV Veghel (NL)
(74) Representative: de Bruijn, Leendert C.

(56) References cited:
- EP-A- 0 095 271
- US-A- 4 343 528
- US-A- 4 410 222
- US-A- 4 753 608

## Description

The present invention relates to a cable connector as defined in the preamble of claim 1. Such a cable connector is known from EP-A-0,095,271.

Another, similar cable connector is known from Unites States patent 4.410.222 which discloses a connector assembly comprising a female connector connected to the ribbon cable and a male connector connected to a circuit member. The female connector comprises a first housing comprising plug-on contact members for connection to conductors of the ribbon cable and a second housing, the ribbon cable in use being clamped between the first and second housing.

A connector module generally comprises a housing of electrically insulative material which accommodates a plurality of contact elements or terminals arranged in rows and columns. The contact elements have a base section and a contact end and connecting end extending from opposite ends of the base section. The connecting ends project outside one side of the housing and are connected to a printed circuit board.

There have long been attempts to accommodate electronic circuits in as modular a design as possible on printed circuit boards of standard dimensions. The interconnections between the individual modules and components, such as recorders, playback devices, etc., are preferably made via electronic connectors. As a consequence of miniaturization and due to the high density of present day integrated circuits, a large number of electronic components can be mounted on a printed circuit board so that a large number of functions can be carried out by a module of this type. The number of terminals needed for connection to other modules has, likewise, increased.

As a result, there is a great need for connectors with a high contact element density, i.e., with a large number of electrical contacts or terminals per unit of volume. The need for connectors with high contact element density has become even greater as a result of the advent of surface mounting technology whereby electronic components are surface mounted to the printed circuit board. Surface mounted devices (SMD) are not mounted on a printed circuit board via the usual pinhole connection but are connected directly to the surface of the printed circuit itself. By surface mounting techniques, it is possible to mount electronic components readily on either surface of a board without interfering with connecting pins which project through the board. This results in a component density which is even higher than that achieved with conventional pinhole connections and a further increase in the number of terminals.

The object of the invention is to provide a cable connector which is designed in such a way that identical cable connectors may be mounted to a printed circuit board adjacent to each other without loss of space for one or more contact elements.

A further object of the invention is to provide a cable connector which is designed in such a way that undesired electrical contact between conductors of the ribbon cable within the cable connector, in the assembled state, is prevented.

A still further object is to provide a cable connector designed in such a way that when two identical cable connectors in the assembled state are mounted opposite each other conductors within one cable conductor will not touch conductors within the other cable connector.

Therefore, the cable connector according to the invention is characterized by the features of the characterizing portion of claim 1.

The through channels make easy assembly of the ribbon cable possible. In the case of two cable connectors located opposite each other and connected to, for example, a four column connector, the displaced sitting of the contact elements achieves the result that, the ends, lying opposite each other, of the individual cores of the ribbon cables connected to the respective cable connectors always have a mutual distance equal to the width of one row. Accordingly, there is no danger of the conductors situated opposite each other being able to make electrical contact with each other, assuming that the end to be connected of each ribbon cable is finished in accordance with the position of the contact elements.

In a first embodiment of the invention the cable connector is characterized in that said cable connector comprises two columns and an even number of contact elements within each column.

Preferably, the pitch distance between adjacent contact elements is 2 mm.

Moreover, it is preferred that the housing of said cable connector has external dimensions such that two or more of said cable connectors can be positioned adjacent to each other without loss of space for one or more contact elements.

By using contact elements with a flat base section, the external dimensions of the cable connector are such that no space is lost for one or more of the contact elements. As a result, two or more cable connectors may be connected directly adjoining, for example, a four column connector according to the invention.

In this application, the term "printed circuit board", which is also commonly referred to as "printing wiring board", is understood as meaning, in general, substrates with conducting tracks and thus, for example, also substrates of liquid crystal displays.

In the text which follows, the invention will be illustrated in detail by reference to a drawing in which:
figure 1 shows diagrammatically in perspective a printed wiring board, to which several connectors and ribbon cable connectors are connected;
figure 2 shows diagrammatically in perspective two cable connectors located opposite each other for a ribbon cable which can be connected to a four column connector.

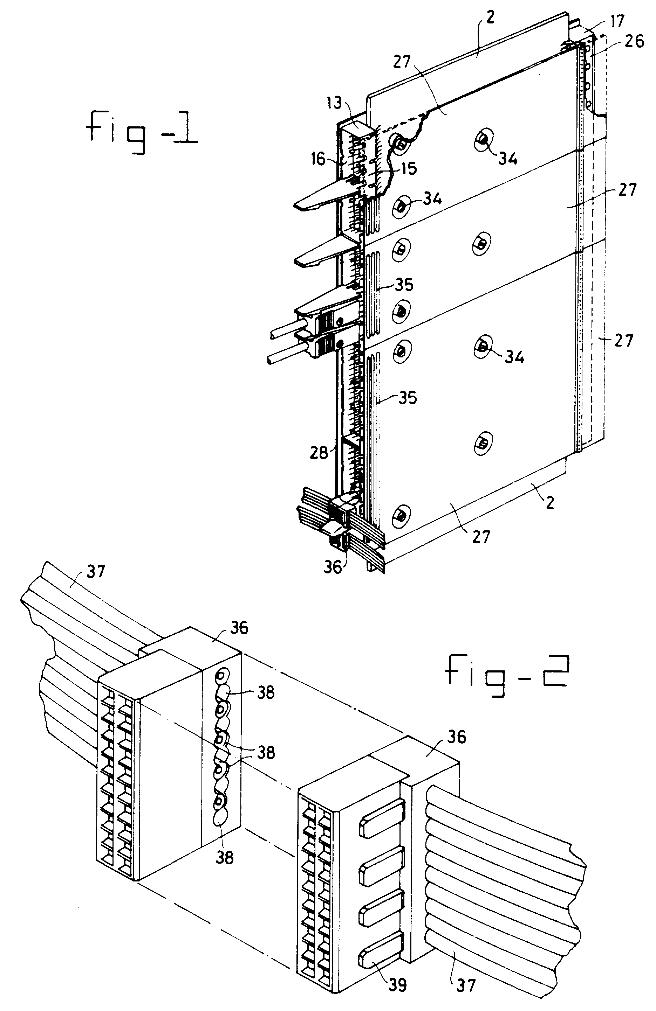

Figure 1 shows a printed circuit board 2 with connectors as described and claimed in parent European patent application 0,393,251 fitted on opposite sides. Several protective plates 27, 28 of different dimensions are mounted on the two flat sides of the printed wiring board 2. Openings 34 are formed in the protective plates 27 in a manner such that the protective plates can be mechanically connected to the printed circuit board 2 by means of, for example, screws and spacers. This results in the desired strong mechanical connection between the diverse connectors and the printed wiring board. At the position of the sidewalls 15, 16 of the connectors 13, the protective plates are provided with ribs 35 extending in the longitudinal direction of the connectors 13. This increases the mechanical stability of the protective plates and prevents the protective plates from being bent during rough contact of the connectors 13. It should be clear that ribs 35 extending in the transverse direction (not shown) across the protective plates may also be provided with the same object.

It may be necessary, particularly in elaborate systems, to connect parts of one connector with parts of another connector or with another printed circuit board. At the bottom left in figure 1, four adjoining cable connectors 36 of the type illustrated in figure 2 are shown mounted to the connector 13. The cable connectors 36 adjoin each other in figure 1 without loss of space for one or more contact elements.

In figure 2, two cable connector modules having a housing 36 with two columns of contact openings located opposite each other at a distance are shown diagrammatically in perspective on an enlarged scale. The ribbon cables 37 have conductors disposed opposite each other in the open channels 38 of the respective cable connectors. The channels extend in the row direction of the contact elements from one side of the housing to the other. To prevent these conductors making undesired electrical contact with each other, the contact elements of the cable connectors 36 are so arranged that only one connecting end of a contact element is situated in each channel 38 so that, if two ribbon cable connectors are positioned opposite each other, the respective contact elements in the same row are separated from each other over at least a distance of one position. By further providing that the end of a ribbon cable 37 to be received in a cable connector has a course corresponding to the sitting of the connecting ends of the contact elements so that after assembly of the ribbon cable, the conductors of the contacting extremities do not project beyond the housing 36, the ends of the contacted conductors will then not touch each other when the cable connectors are mounted opposite each other.

The contact elements can, of course, be arranged in different ways. For example, adjoining contact elements of a two column cable connector with an even number of rows can each be located in a differen column with the end of the ribbon cable 37 to be received in the cable connector having a castellated course. The contact elements may have a flat base section from which contact fingers or a contact pin extend with the connecting end being designed as a plug-on contact (not shown). The pitch distance between the contact elements is preferably 2 mm. In figure 2 projections 39, which can be broken away, are attached to avoid erroneous contacting.

It will be clear that the invention is not limited to the preferred embodiments thereof described and shown in the drawings, but that other variations and modifications are possible. For example, the connector modules may include optoelectronic connectors connected to optical fiber cables, shielded connectors, to locking means or so called polarity indicators to prevent incorrect connection of the connector modules, etc., all without deviating from the scope of the invention, which is defined by the claims.

## Claims

1. A cable connector for a ribbon cable (37), comprising a housing of electrically insulating material with a plurality of contact elements, each contact element accommodated within a predetermined cavity and having a connecting portion formed as a plug-on contact for connection to a conductor of the ribbon cable (37), the connecting portions being equidistantly arranged in a plurality of columns, wherein the position of each connecting portion in a predetermined column is shifted relative to the position of adjacent connecting portions in an adjacent column by one half the distance between two adjacent connecting portions within one single column, said housing having an opening extending from a first side to a second opposing side for receiving said ribbon cable (3j), said opening comprising a series of open channels (38) entirely enclosed by said housing and extending perpendicular to the direction of the columns, only one connection portion being located in each channel (38) characterized in that the contact terminals are arranged within the corresponding cavities such that any line in the plane of said series of open channels and perpendicular to the direction of the columns is intersected by one contact terminal only.

2. A cable connector according to claim 1 characterized in that said cable connector comprises two columns and an even number of contact elements within each column.

3. A cable connector according to any of the preceding claims characterized in that the cavities in the cable connector are arranged in rows and columns, the mutual distance between adjacent cavities within any column being equal to the mutual distance between adjacent conductors of said ribbon cable, the cavities within any column alternately accommodating one of said contact terminals and being unused.

4. A cable connector according to any of the preceding claims characterized in that the pitch distance between adjacent contact elements is 2 mm.

5. A cable connector according to any of the preceding claims characterized in that the contact elements have a flat base section.

6. A cable connector according to any of the preceding claims characterized in that the housing of said cable connector has external dimensions such that two or more of said cable connectors can be positioned adjacent to each other without loss of space for one or more contact elements.

## Patentansprüche

1. Kabelverbinder für ein Bandkabel (37), umfassend ein Gehäuse aus elektrisch isolierendem Material mit einer Mehrzahl von Kontaktelementen, wobei jedes Kontaktelement in einem vorbestimmten Hohlraum untergebracht ist und einen Verbindungsabschnitt aufweist, der als Aufsteckkontakt zur Verbindung mit einem Leitungsdraht des Bandkabels (37) ausgebildet ist, wobei die Verbindungsabschnitte abstandsgleich in einer Mehrzahl von Spalten angeordnet sind, wobei die Position jedes Verbindungsabschnitts in einer vorbestimmten Spalte bezogen auf die Position benachbarter Verbindungsabschnitte in einer benachbarten Spalte um eine Hälfte des Abstands zwischen zwei benachbarten Verbindungsabschnitten in einer einzelnen Spalte verschoben ist, wobei das Gehäuse zur Aufnahme des Bandkabels (37) eine Öffnung aufweist, die sich von einer ersten Seite bis zu einer zweiten entgegengesetzten Seite erstreckt, wobei die Öffnung eine Folge von offenen Kanälen (38) umfaßt, die vollständig vom Gehäuse umschlossen sind und sich senkrecht zur Richtung der Spalten erstrecken, wobei in jedem Kanal (38) nur ein Verbindungsabschnitt angeordnet ist, dadurch gekennzeichnet, daß die Kontaktanschlüsse in den entsprechenden Hohlräumen derart angeordnet sind, daß jede Linie in der Ebene der Folge von offenen Kanälen und senkrecht zur Richtung der Spalten nur von einem Kontaktanschluß gekreuzt wird.

2. Kabelverbinder nach Anspruch 1, dadurch gekennzeichnet, daß der Kabelverbinder zwei Spalten und eine gerade Anzahl von Kontaktelementen in jeder Spalte umfaßt.

3. Kabelverbindender nach einem der vorangehenden Ansprüche, dadurch gekennzeichnet, daß die Hohlräume im Kabelverbinder in Reihen und Spalten angeordnet sind, wobei der gegenseitige Abstand zwischen benachbarten Hohlräumen in jeder Spalte gleich dem gegenseitigen Abstand zwischen benachbarten Leitungsdrähten des Bandkabels ist, wobei die Hohlräume in jeder Spalte abwechselnd einen der Kontaktanschlüsse aufnehmen und unbenutzt sind.

4. Kabelverbinder nach einem der vorangehenden Ansprüche, dadurch gekennzeichnet, daß der Teilungsabstand zwischen benachbarten Kontaktelementen 2 mm beträgt.

5. Kabelverbinder nach einem der vorangehenden Ansprüche, dadurch gekennzeichnet, daß die Kontaktelemente einen flachen Basisteil besitzen.

6. Kabelverbinder nach einem der vorangehenden Ansprüche, dadurch gekennzeichnet, daß das Gehäuse des Kabelverbinders derartige Außenabmessungen aufweist, daß zwei oder mehr der Kabelverbinder ohne Platzverlust für ein oder mehrere Kontaktelemente aneinander angrenzend angeordnet werden können.

## Revendications

1. Un connecteur de câble pour un câble-ruban (37), comprenant un boîtier en un matériau électriquement isolant avec une pluralité d'éléments de contact, chaque élément de contact étant logé à l'intérieur d'une cavité prédéterminée et présentant une partie de connexion formée comme un contact à broche d'enfichage pour la connexion vers un conducteur du câble-ruban (37), les parties de connexion étant disposées de façon équidistante dans une pluralité de colonnes, dans lequel la position de chaque partie de connexion dans une colonne prédéterminée est décalée par rapport à la position des parties de connexion adjacentes dans une colonne adjacente de la moitié de la distance entre deux parties de connexion adjacentes à l'intérieur d'une colonne unique, ledit boîtier présentant une ouverture s'étendant depuis une première face jusqu'à une deuxième face opposée pour recevoir ledit câble-ruban (37), ladite ouverture comprenant une série de canaux ouverts (38) entièrement entourés par ledit boîtier et s'étendant perpendiculairement à la direction des colonnes, une seule partie de connexion étant disposée dans chaque canal (38), caractérisé en ce que les bornes de contact sont agencées à l'intérieur des cavités correspondantes de telle façon qu'une ligne quelconque dans le plan de ladite série d'ouvertures et perpendiculaire à la direction des colonnes soit coupée par une seule borne de contact, uniquement.

2. Un connecteur de câble selon la revendication 1, caractérisé en ce que ledit connecteur de câble comporte deux colonnes et un nombre pair d'éléments de contact à l'intérieur de chaque colonne.

3. Un connecteur de câble selon l'une quelconque des revendications précédentes, caractérisé en ce que les cavités dans le connecteur de câble sont agencées en rangées et en colonnes, la distance réciproque entre des cavités adjacentes à l'intérieur d'une colonne quelconque étant égale à la distance réciproque entre des conducteurs adjacents dudit câble-ruban, les cavités à l'intérieur d'une colonne quelconque, de façon alternée, logeant l'une desdites bornes de contact et étant inutilisées.

4. Un connecteur de câble selon l'une quelconque des revendications précédentes, caractérisé en ce que la distance de pas entre des éléments de contact adjacents est de 2 mm.

5. Un connecteur de câble selon l'une quelconque des revendications précédentes, caractérisé en ce que les éléments de contact présentent un tronçon de base plat.

6. Un connecteur de câble selon l'une quelconque des revendications précédentes, caractérisé en ce que le boîtier dudit connecteur de câble présente des dimensions extérieures telles qu'au moins deux desdits connecteurs de câble peuvent être positionnés adjacents l'un à l'autre sans perte d'espace pour un ou plusieurs éléments de contact.
